# EUROPEAN PATENT APPLICATION

(11) **EP 2 045 630 A1**
(43) Date of publication of application: **08.04.2009**
(21) Application number: 06832809.5
(22) Date of filing: 17.11.2006
(51) Int. Cl.: G02B 5/08, C23C 14/34, G02B 5/10, G11B 7/24, G11B 7/258, G11B 7/26

(54) **THIN FILM FOR REFLECTIVE FILM OR SEMI-TRANSMITTING REFLECTIVE FILM, SPUTTERING TARGET, AND OPTICAL RECORDING MEDIUM**

(71) Applicant: Tanaka Kikinzoku Kogyo K.K., Chiyoda-ku Tokyo 100-6422 (JP)
(72) Inventor: OBATA, Tomokazu, Isehara-shi Kanagawa 259-1146 (JP); YANAGIHARA, Hiroshi, Isehara-shi Kanagawa 259-1146 (JP)
(74) Representative: Setna, Rohan P.
(86) International application number: PCT/JP2006/322930
(87) International publication number: WO 2008/059579

(57) **Abstract**

The present invention provides a thin film for a reflection film or for a semi-transparent reflection film, which has at least one silver compound phase of nitride, oxide, complex oxide, nitroxide, carbide, sulfide, chloride, silicide, fluoride, boride, hydride, phosphide, selenide and telluride of silver, dispersed in a matrix formed of silver. The thin film according to the present invention keeps its reflectance without significant loss even after a long period of use, and can prolong the life of various devices which comprises the thin film as a reflection film, such as an optical recording medium and a display. The thin film can be also applied to a semi-reflective/semi-transparent film used in the optical recording medium.

## Description

### TECHNICAL FIELD

The present invention relates to a thin film useful as a reflection film or a semi-transparent reflection film used in an optical recording medium, a display and the like. The present invention particularly relates to a thin film which shows reflectance that does not decrease even after having been used for a long period of time, and the optical recording medium having the thin film as the reflection film or the semi-transparent reflection film.

### BACKGROUND ART

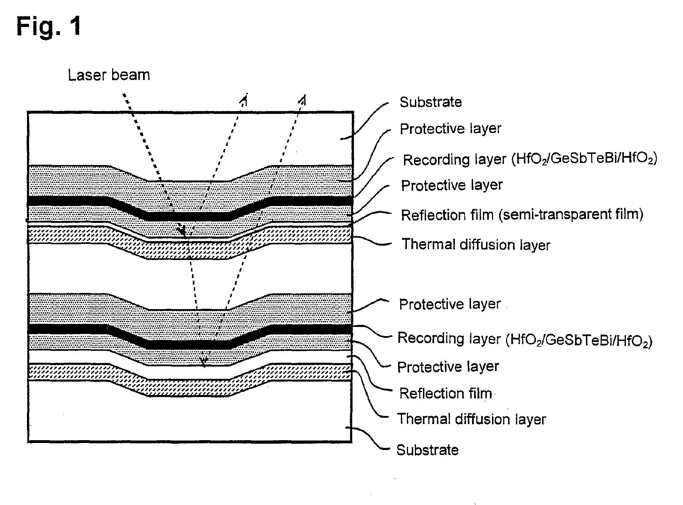

An optical recording medium, such as a CD-R/RW, a DVD-R/RW/RAM and a Blue-Ray disk, and a display device, such as a liquid crystal display and an organic luminescent display have at least one layer of a reflection film formed therein. For instance, Figure 1 shows a structure of an HD-DVD (one-sided, dual-layer rewritable disk) which has been developed in recent years, as an example of the optical recording medium. As shown in the example, the optical recording medium has a multilayer structure comprising the reflection film in addition to a recording layer which plays a predominant role of a function of the optical recording medium, a protective layer and a thermal diffusion layer.

Many conventional reflection films are made from silver. This is because silver has a high reflectivity and is less expensive than gold having the high reflectivity similarly to silver. Silver also has excellent optical transparency when the film thickness is appropriately adjusted, accordingly can be possibly used as a semi-transparent reflection film, and from this fact, has been applied to an optical recording medium being developed now (cf. Fig. 1).

On the other hand, silver has a problem of undergoing a color change into black through being corroded to decrease its reflectance, because of being inferior in corrosion resistance. The factor of causing corrosion in a reflection film is, for instance, an organic dye applied in a recording layer of an optical recording medium, though it varies depending on an applied medium and device. Then, the reflection film shows lower reflectance after having been corroded by the organic dye for a long period of use. In addition, the reflection film in a display device may cause corrosion due to the atmospheric moisture. For this reason, a thin film made from a silver alloy has been developed which contains various elements in a silver matrix, so as to solve the problem of the corrosion resistance of silver.

For instance, Patent Document 1 discloses a silver alloy containing 0.5 to 10 atom% ruthenium and 0.1 to 10 atom% aluminum, and Patent Document 2 discloses a silver alloy containing 0.5 to 4.9 atom% palladium. In addition, Patent Document 3 and Patent Document 4 disclose a silver alloy containing Ca, V and Nb, and the like.
Patent Document 1: Japanese Patent Laid-Open No. 11-134715
Patent Document 2: Japanese Patent Laid-Open No. 2000-109943
Patent Document 3: Japanese Patent Laid-Open No. 6-243509
Patent Document 4: Japanese Patent Laid-Open No. 2003-6926

### DISCLOSURE OF THE INVENTION

A thin film composed of the above described silver alloy shows a certain effect of having improved corrosion resistance. Then, a problem of the corrosion should have been solved, but an optical recording medium using a thin film formed from the silver alloy still can not completely inhibit a recording error caused by degradation of the reflection film. On the other hand, a material more excellent in reflectance-keeping characteristics than ever has been required along with requirement to a further improvement of a recording speed and recording density toward future.

On the basis of the background, the present invention is directed at providing a thin film that is applied to a reflection film and a semi-transparent reflection film, which compose an optical recording medium, a display and the like, and that can function without decreasing its reflectivity even after a long period of use; and a production method therefor.

In order to solve such a problem, the present inventors made an extensive research on a mechanism how a silver thin film degrades its reflecting characteristics, and found that the factor of the degradation is not only in simple corrosion (blackening) but also in a phenomenon that silver atoms migrate while the thin film is heated. The phenomenon of the migration of the silver atoms is a phenomenon that silver atoms composing a flat thin film right after having been formed migrate toward an energetically stable state through being driven by a given environmental condition. At this time, the silver atoms migrate not only in a planar direction but also in a three-dimensional direction in many cases, and as a result, cohere into a polygonal shape close to a sphere. When such a three-dimensionally cohered body is formed in the thin film, a laser beam incident on the thin film is reflected toward irregular directions with respect to an incident axis and consequently toward many directions. Accordingly, an optical recording medium employing such a thin film for a reflection film reflects less light toward a sensor of an optical recording device in a sensor axis direction, and consequently causes an error in the recording medium.

The above described phenomenon of the migration and cohesion of silver atoms differs from a corrosion phenomenon, is not sufficiently solved by only using an alloy, which has been a conventional measure, and is preferably solved by preventing the migration of the silver atoms composing the thin film.

Then, the present inventors studied a technique for inhibiting silver atoms from migrating in a thin film, found that it is preferable for inhibiting the silver atoms from migrating to disperse a silver compound phase which is not silver (pure silver) in a silver matrix, and becomes possible to form a silver thin film superior in reflectance-keeping characteristics, and arrived at the present invention.

Specifically, the present invention provides a thin film for a reflection film or a semi-transparent reflection film, which includes at least one silver compound phase of nitride, oxide, complex oxide, nitroxide, carbide, sulfide, chloride, silicide, fluoride, boride, hydride, phosphide, selenide and telluride of silver, dispersed in a matrix formed of silver.

In the present invention, a silver compound composing a silver compound phase includes nitride, oxide, carbide, sulfide, chloride, silicide, fluoride, boride, phosphide, selenide and telluride. By dispersing the phase consisting of these silver compounds in a silver matrix, it becomes possible to inhibit the migration of silver atoms composing the matrix, to maintain the flatness of a thin film, and thereby to inhibit the reflectance from lowering even when the thin film has received heat.

Specific examples of a silver compound phase are shown in Table 1. These silver compounds include a compound in a stoichiometrically nonequilibrium state, in addition to compounds having a composition in a stoichiometrically equilibrium state as shown in Table 1, which makes the compounds stably exist; and accordingly, for instance, AgN (silver nitride) includes AgₓN₁₋ₓ (O <x <1).

**[Table 1]**

| | |
|---|---|
| Nitride | AgN (Ag₁₋ₓNₓ) |
| Oxide | Ag₂O,AgO (Ag₁₋ₓOₓ) |
| Carbide | AgC (Ag₁₋ₓCₓ) |
| Sulfide | Ag₂S (Ag₂₋ₓSₓ) |
| Fluoride | AgF (Ag₁₋ₓFₓ) |
| Boride | AgB (Ag₁₋ₓBₓ) |
| Silicide | AgSi (Ag₁₋ₓSiₓ) |
| Chloride | AgCl (Ag₁₋ₓClₓ) |
| Phosphide | AgP (Ag₁₋ₓPₓ) |
| Selenide | Ag₂Se (Ag₂₋ₓSeₓ) |
| Telluride | Ag₂Te (Ag₂₋ₓTeₓ) |
| | Ag₂MO₄Ag₂WO₄ |
| Complex oxide | AgVO₃Ag₂CrO₄ |
| | Ag₄P₂O₇Ag₃PO₄ |

The silver compound phase is preferably contained in an amount of 0.001 to 2.5 wt.%. The silver compound in an amount of 0.001 wt.% or more is necessary for sufficiently inhibiting the migration of silver atoms. In addition, the upper limit is set at 2.5 wt.% because the silver compound contained above the upper limit imparts an insufficient initial reflectivity to the thin film. Accordingly, the content of the silver compound phase is preferably 0.001 to 1.0 wt.%, and further preferably is 0.001 to 0.5 wt.%. As the content of the silver compound increases, the effect of inhibiting the deterioration in reflectivity increases but the reflectivity tends to deteriorate. It is preferable to control the content of the silver compound depending on an application field within the above described range. In the above description, the content of the silver compound phase is based on the total weight of the thin film (the total weight of the matrix and the silver compound phase).

A silver compound phase is preferably in a particulate form composed of many molecules of the compound, but is not always limited to this form. Specifically, the silver compound phase may be formed of molecules of at least one compound. The size of the silver compound phase is preferably controlled into 1/10 or less of a thickness of a thin film. For instance, when the thickness of the thin film is set at 1,000 Å, the silver compound phase preferably has a size of 100 Å or smaller, and when the thickness of the thin film is set at 120 Å, the dispersing silver compound phase preferably has a size of 12 A or smaller.

In the next place, a method for producing a thin film according to the present invention will be described. A reflection film according to the present invention has preferably a thickness of 120 to 1,200 Å when applied to an optical recording medium, a display and the like. When producing such a thin film, it is preferably to apply a sputtering technique as a production method. When applying the sputtering technique for producing the thin film containing a silver compound phase, the technique includes two directions which will be described below.

A first technique is a method of using a target having a structure and a composition similar to a thin film to be produced, specifically, is a method of using a target prepared by dispersing at least one silver compound phase of nitride, oxide, complex oxide, nitroxide, carbide, sulfide, chloride, silicide, fluoride, boride, hydride, phosphide, selenide and telluride of silver, in a matrix formed of silver. The method can produce the thin film with the use of one sheet of target, accordingly can produce the thin film by a sputtering technique with a form of arranging the target so as to face a substrate, which is ordinarily employed when producing a reflection film, and consequently produce the thin film with adequate productivity. Here, there are further three forms in the sputtering target for producing the thin film according to the present invention, as will be described below.

A first form is an internally chemically-combined type target. The internally chemically-combined type target is prepared by heat-treating a raw material made from silver (pure silver) in an atmosphere of high-pressure oxygen gas, nitrogen gas or the like to chemically combine the interior partially with oxygen or nitrogen or the like into the oxide, the nitride or the like. The target in the form is useful for producing a thin film containing the oxide or the nitride as a silver compound phase. The raw material described in the above may have a tabular shape close to the shape of the target, or may be prepared by employing a granular material, chemically combining the interior with other elements for the raw material, and then compression-molding the resultant granular material.

A second form to be used is a sintered target. The sintered target is prepared by mixing a powder of silver (pure silver) with a powder of a silver compound depending on a composition to be aimed, compressing and molding the mixed powder, and sintering the compact. The sintered target is useful for producing a thin film which is hardly produced by the above described internally chemically-combined type target, and is preferable for producing such a thin film as to disperse silver carbide, silver boride and silver silicide as a silver compound in the matrix.

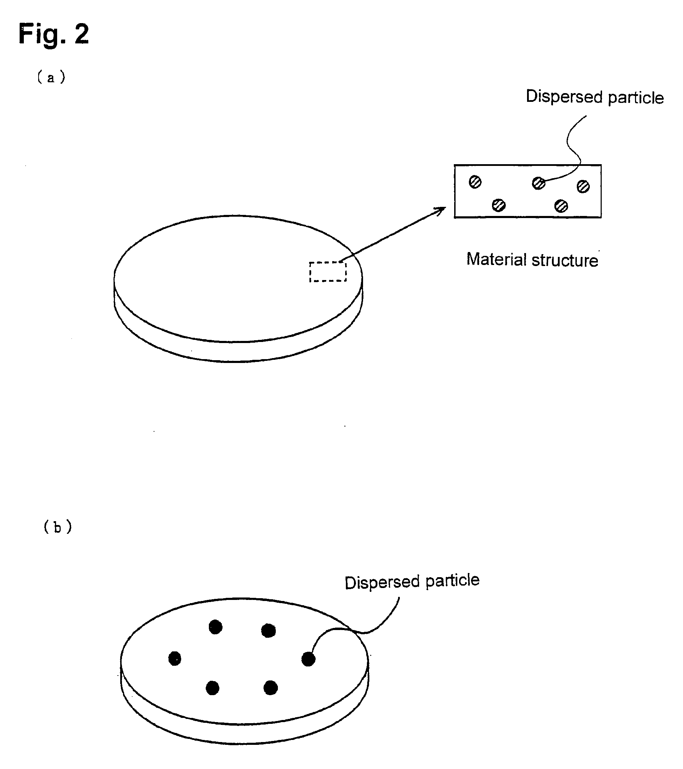

A third form is an embedded type target. The embedded type target is prepared by embedding a small piece (with a cylindrical shape and a spherical shape though the shape is not limited) of a silver compound which is to be a dispersing particle, into a region to be consumed by sputtering in a target made from pure silver. The above described internally chemically-combined type target and sintered target have a composition and a structure microscopically close to those of a thin film to be produced, as is shown in Fig. 2(a), whereas this target has those macroscopically close to the thin film to be produced, as is shown in Fig. 2(b). When the target is used, the composition of the thin film to be produced can be controlled by changing a diameter of the small piece of the silver compound to be embedded, positions of the small pieces to be arranged, the number of the pieces and a sputtering rate.

In the above described three types of targets, a content of a silver compound phase is preferably controlled so as to have the same composition as a thin film to be produced. Accordingly, the content of the silver compound is preferably 0.001 to 2.5 wt.%, more preferably is 0.001 to 1.0 wt.%, and further preferably is 0.001 to 0.5 wt.%. In addition, the size of the silver compound phase in these targets is not limited in particular, and may be the same molecular level as in the case of the thin film to be produced, or may be a millimeter order as in the case of the embedded type target. This is because whatever the size of the silver compound phase, a compound is sputtered in a molecule unit when being sputtered, and the formed thin film acquires the composition to be aimed.

On the other hand, it is possible to produce a thin film according to the present invention even without using such one sheet of an integrated target as described above. This second direction is to improve a sputtering condition. In this method, an easily-available pure silver target can be used and the specially integrated target is not needed. The method is useful when it is difficult to prepare a special target such as an internally chemically-combined type target as was described above. In the second direction, there are further two applicable techniques which will be described below.

A first technique is a co-sputtering technique with the use of a plurality of targets. The technique is a method of simultaneously sputtering a plurality of targets made from a compound having the same composition as a phase composing a thin film, and made from the same metal. For instance, the thin film having silver oxides dispersed in silver can be produced by using two targets of a pure silver target and a silver oxide (AgO) target, placing them together in a chamber, and simultaneously sputtering the two targets.

In addition, it is particularly useful in a second direction for improving a sputtering condition to employ a reactive sputtering technique. The reactive sputtering is a technique of adding a reactive gas such as oxygen and nitrogen into an atmosphere for sputtering, sputtering the target, and forming a thin film while oxidizing or nitriding one part of a particle sputtered from a target. The reactive sputtering technique is a useful method when a silver compound to be dispersed in the thin film is expensive, is not available or is difficult to be chemically prepared.

The reactive sputtering technique may be singly used, but may be used in combination with another technique. For instance, when using the above described special integral target, specifically, using an internally chemically-combined target, a sintered target and an embedded type target, and when it is anticipated that an amount of a dispersed silver compound in a thin film will be insufficient only by independently using the targets, it is possible to increase a content of a silver compound in the thin film by introducing a reactive gas into an atmosphere in a sputtering apparatus. In addition, when producing a thin film by using a co-sputtering technique as well, it is possible to adjust the amount of the silver compound by using the reactive sputtering technique in combination with the co-sputtering technique.

### Brief Description of the Drawings

Fig. 1 illustrates an example of a structure for an HD-DVD; and
Fig. 2 illustrates specific examples of a sputtering target for producing a reflection film or a semi-transparent reflection film according to the present invention.

### Best Mode for Carrying Out the Invention

In the present embodiment, at first, three targets were produced which were an internally chemically-combined type target, a sintered type target and an embedded type target. Then, a thin film was produced not only by using these targets, but also by using a co-sputtering technique and a reactive sputtering technique.

### A: Production of sputtering target

### (a) Inner-part chemically-combined type target

A internally chemically-combined type target was prepared by the steps of: preparing 2.5 kg of a granular raw material of pure silver with a particle diameter of 0.5 to 1.0 mm; charging it into a high-pressure reactive pot; replacing the air inside the pot sufficiently with nitrogen gas; increasing a pressure and a temperature respectively to a nitrogen gas pressure of 1.0 MPa and 850°C; and keeping the pot in the state for 6 hours for subjecting pure silver to internal nitriding; then, slowly cooling the internally nitrided silver grains; taking them out; charging them into a die; high-pressure-extruding them at 750°C into an integrated compact; forging the compact; rolling the forged compact into a plate (with size of 160 mm × 160 mm × 6 mm); and the cutting the plate into a sputtering target having a standard size (with a diameter of 152 mm (6 inches) and a thickness of 5 mm). The target had a composition of Ag/0.001 wt.% AgN in which silver nitride of a compound phase was dispersed in a silver matrix. The target corresponds to the sample No. 1 which will be described later.

In addition to the above described target, other internally chemically-combined type targets were prepared which had compositions of Ag/0.01 wt.% AgN (sample No. 2) and Ag/0.001 wt.% Ag₂O (sample No. 6). As for these targets, the target of the sample No. 2 was produced by setting a retaining period of time for subjecting the pure silver to internal nitriding, at 15 hours; and the target of the sample No. 6 was produced by the steps of replacing the air inside the high-pressure reactive pot with oxygen gas (into gas pressure of 0.4 MPa) and reacting pure silver grains with oxygen at 850°C for 10 hours.

### (b) Sintered type target

A sintered type target was produced by the steps of: preparing a powder of pure silver and a powder of silver nitride both with particle sizes of 75 to 100 µm; weighing the powders so as to form an aimed composition; sufficiently mixing them; then charging the mixture into a die made from carbon; pressing the mixture to form a green compact; then sintering the green compact in a vacuum sintering furnace at 600°C for 24 hours to form a sintered compact; forging and rolling the compact into a plate for further improving a densed degree; and then cutting the plate into a sputtering target with the same standard size as described previously. The target had a composition of Ag/0.5 wt.% AgN. The target corresponds to the sample No. 3 which will be described later.

### (c) Embedded type target

An embedded type target was produced by the steps of: preparing a disc with a standard size (with a diameter of 152 mm (6 inches) and a thickness of 5 mm) made from pure silver; perforating three round holes with a diameter of 1.05 mm at equal spaces so as to form a circle with a diameter of 80 mm; inserting round bars made from silver oxide with a diameter of 1.0 mm and a length of 5 mm into the round holes; and caulking perimeters of the round bars so that the round bars will not drop off and could be fixed. The target had a composition of Ag/1.0 wt.% Ag₂O. The target corresponds to the sample No. 10 which will be described later.

As for the embedded type target, a target corresponding to a composition equivalent to Ag/0.1 wt.% AgC (sample No. 12) was produced, in addition to the above described target. In the above target, six round rods with a diameter of 0.50 mm made from silver carbide were inserted and fixed in round holes with a diameter of 0.55 mm.

### B: Production of thin film

A thin film was produced by using the above described various targets, and by employing a co-sputtering technique and a reactive sputtering technique. Here, the thin film was formed on a polycarbonate substrate for DVD. The substrate (with a diameter of 120 mm and a sheet thickness of 0.6 mm) was produced through an injection molding machine provided with a stamper, in which a pre-format pattern was formed. On the top face of the substrate, the reflection film was formed into a film thickness of 120 Å with each method.
(i) A thin film was formed on a polycarbonate substrate by using each of three targets produced in the above described items (a) to (c). Setting each target in a sputtering chamber; and evacuating the chamber; introducing Ar gas till the pressure reaches 5.0×10⁻¹ Pa; placing a substrate right under the target in a resting state; and sputtering the target at a direct current of 0.4 kW for eight seconds. Then, the thickness of the resulting film was distributed within ±10%.
(ii) Cosputtering

Two targets of a pure silver target and an Ag-0.1 wt.% AgC target corresponding to the above described sample No. 12 were set at two positions among three-divided positions which are located on a concentric circle having a radius of 160 mm from the center axis of a sputtering apparatus. Then, the inside of the apparatus was evacuated, and Ar gas was introduced until the pressure reached 5.0×10⁻¹ Pa. Subsequently, the thin film was formed on a substrate by the steps of mounting the substrate on the center of a turntable; rotating the turntable at 10 rpm; and applying sputtering electric powers of a direct current of 0.99 kW to the pure silver target and a direct current of 0.01 kW to the Ag-0.1 wt.% AgC target to sputter the targets for eight seconds. Thus produced thin film had a composition of Ag/0.001 wt.% AgC. The composition corresponds to a sample No. 11 which will be described later. The thickness of the above produced film was distributed within ±10%. By employing the co-sputtering technique, the composition of the thin film can be adjusted by changing the composition of a target used in combination with the pure silver target. The thin films of the samples No. 9 and 13 to 31 were produced by the method in the present embodiment as well.

### (iii) Reactive sputtering

A pure silver target was set in a sputtering apparatus, the apparatus was evacuated, and Ar gas was introduced till the pressure reached 5.0×10⁻¹ Pa. Subsequently, nitrogen gas was introduced as a reactive gas. A partial pressure of the nitrogen gas was controlled into 5.0×10⁻² Pa. Then, a thin film was produced on a substrate by placing the substrate right under the target in a resting state, and sputtering the target at a direct current of 0.4 kW for eight seconds. Thus produced thin film had a composition of Ag/1.0 wt.% AgN. The composition corresponds to a sample No. 4 which will be described later. By employing the reactive sputtering technique, the composition of the thin film can be adjusted by increasing or decreasing the partial pressure of the reactive gas. The thin films of the samples No. 5, 7 and 8 were produced by the method in the present embodiment as well.

### C: Evaluation of thin film

A thin film was evaluated by evaluating characteristics of a DVD medium which was prepared by forming a thin film on a polycarbonate substrate in the above described manner. The evaluation was conducted by the steps of: measuring a jitter value, a PI error, a PO failure and a reflectance of the DVD medium in an initial state after having been prepared with the use of an optical disc evaluation instrument (optical disc evaluation instrument ODU-1000 made by Pulstec Industrial Co., Ltd.); confirming whether they were within a range of DVD standards; subsequently subjecting the DVD medium to an accelerating environmental test of exposing the DVD medium into an environment of a temperature of 80°C and a relative humidity of 85% for 500 hours; and measuring the respective values of the DVD medium after having been subjected to the accelerating environmental test by using the evaluation instrument. The results are shown in Table 2. The table also shows the result of a similar test on a DVD medium having a pure silver film formed thereon as a reflection film.

**[Table 2]**

| Sample No. | Sample composition (wt.%) | Method for producing thin film^{*1} | PI error | | PO failure | | Jitter (%) | | Reflectance (%) | |
|---|---|---|---|---|---|---|---|---|---|---|
| | | | Initial stage | After humidifi- cation | Initial stage | After humidification | Initial stage | After humidification | Initial stage | After humidification |
| 1 | Ag/0.001AgN | a | 18.2 | 1176.6 | 0.0 | 6.3 | 6.3 | 21.3 | 56.3 | 52.2 |
| 2 | Ag/0.01AgN | a | 43.6 | 1097.4 | 0.0 | 6.0 | 7.8 | 20.3 | 55.7 | 53.1 |
| 3 | Ag/0.5AgN | b | 23.3 | 932.3 | 0.0 | 5.2 | 7.5 | 17.3 | 54.2 | 51.8 |
| 4 | Ag/1.0AgN | e | 33.3 | 698.9 | 0.0 | 3.7 | 7.4 | 14.3 | 53.4 | 52.3 |
| 5 | Ag/2.5AgN | e | 21.3 | 426.5 | 0.0 | 2.5 | 7.7 | 10.3 | 52.7 | 52.3 |
| 6 | Ag/0.001Ag2O | a | 22.1 | 1456.1 | 0.0 | 7.6 | 7.0 | 23.3 | 53.7 | 49.3 |
| 7 | Ag/0.005Ag2O | e | 24.9 | 1243.2 | 0.0 | 7.1 | 7.6 | 22.3 | 53.1 | 48.8 |
| 8 | Ag/0.05Ag2O | e | 22.5 | 1299.8 | 0.0 | 6.7 | 6.6 | 21.3 | 52.6 | 49.2 |
| 9 | Ag/0.5Ag2O | d | 21.5 | 1013.8 | 0.0 | 5.3 | 7.8 | 19.3 | 51.8 | 48.9 |
| 10 | Ag/1.0Ag2O | c | 17.0 | 857.9 | 0.0 | 4.6 | 6.4 | 17.3 | 50.3 | 49.6 |
| 11 | Ag/0.001AgC | d | 19.6 | 989.4 | 0.0 | 5.5 | 6.8 | 19.3 | 54.6 | 53.4 |
| 12 | Ag/0.1AgC | c | 18.6 | 819.2 | 0.0 | 4.6 | 7.1 | 16.3 | 53.8 | 53.3 |
| 13 | Ag/0.001Ag2S | d | 14.3 | 1452.3 | 0.0 | 7.8 | 6.6 | 24.3 | 53.1 | 51.3 |
| 14 | Ag/0.008Ag2S | d | 18.3 | 1156.0 | 0.0 | 6.8 | 7.8 | 22.3 | 47.5 | 46.5 |
| 15 | Ag/0.001AgF | d | 18.2 | 1109.8 | 0.0 | 6.2 | 7.2 | 21.3 | 46.3 | 45.3 |
| 16 | Ag/0.1AgB | d | 12.8 | 932.6 | 0.0 | 4.8 | 6.4 | 15.3 | 53.4 | 53.1 |
| 17 | Ag/0.001AgSi | d | 25.1 | 1119.9 | 0.0 | 5.8 | 7.4 | 19.3 | 55.1 | 54.7 |
| 18 | Ag/0.1AgSi | d | 24.8 | 872.6 | 0.0 | 4.9 | 7.3 | 18.3 | 54.3 | 53.6 |
| 19 | Ag/0.001AgCl | d | 28.8 | 1376.2 | 0.0 | 7.5 | 6.8 | 23.3 | 53.9 | 52.4 |
| 20 | Ag/0.02AgCl | d | 24.7 | 1366.5 | 0.0 | 7.2 | 6.9 | 24.3 | 52.1 | 50.8 |
| 21 | Ag/0.08AgCl | d | 27.4 | 1144.0 | 0.0 | 6.5 | 7.6 | 22.3 | 49.7 | 48.6 |
| 22 | Ag/0.001AgP | d | 12.6 | 1177.4 | 0.0 | 5.8 | 6.5 | 19.1 | 51.0 | 51.1 |
| 23 | Ag/2.0AgP | d | 25.2 | 1164.0 | 0.0 | 6.0 | 7.5 | 20.2 | 48.5 | 48.5 |
| 24 | Ag/0.001Ag2Se | d | 17.5 | 1270.5 | 0.0 | 6.6 | 7.5 | 21.3 | 51.6 | 50.4 |
| 25 | Ag/0.5Ag2Se | d | 19.4 | 1126.6 | 0.0 | 6.1 | 7.6 | 19.3 | 46.9 | 46.2 |
| 26 | Ag/0.001Ag2Te | d | 27.2 | 1178.4 | 0.0 | 6.8 | 6.3 | 23.3 | 52.1 | 50.5 |
| 27 | Ag/1.0Ag2Te | d | 26.3 | 1142.8 | 0.0 | 5.9 | 6.4 | 20.3 | 45.7 | 45.2 |
| 28 | Ag/1.0Ag2CrO4 | d | 44.2 | 1442.0 0.0 | | 7.0 | 7.4 | 24.7 | 51.4 | 50.8 |
| 29 | Ag/2.5Ag2MoO4 | d | 26.9 | 1350.5 | 0.0 | 7.3 | 6.8 | 24.1 | 48.3 | 46.4 |
| 30 | Ag/2.5AgVO3 | d | 43.7 | 1295.0 | 0.0 | 7.0 | 6.4 | 20.9 | 49.1 | 49.2 |
| 31 | Ag/2.5Ag2WO4 | d | 16.1 | 1396.8 | 0.0 | 7.2 | 6.9 | 23.2 | 48.9 | 48.0 |
| | Ag100.0 | - | 23.8 | 1664.0 | 0.0 | 8.0 | 6.5 | 27.0 | 57.0 | 51.5 |

| | | | | | | | | | | |
|---|---|---|---|---|---|---|---|---|---|---|
| ^{*1} Methods for producing each thin film are described below. a: having used internally chemically-combined type target b: having used sintering type target c: having used embedded type target d: co-sputtering e: reactive sputtering | | | | | | | | | | |

As is understood from Table 2, it was confirmed that a recording medium provided with a reflection film having a silver compound phase dispersed therein according to the present invention showed less occurrences of a PI error and a PO failure and further a lower decreasing rate of a reflectance than a DVD medium provided with a reflection film formed from pure silver. For information, the DVD medium provided with the reflection film formed from pure silver was not recognized by a recording device after a humidification test, and became unusable.

### INDUSTRIAL APPLICABILITY

As described above, a thin film according to the present invention makes the reflectance little lowered even after a long period of use, and can prolong the life of various devices which use the thin film as a reflection film, such as an optical recording medium and a display. The reflection film according to the present invention has also reflectance-keeping characteristics which are little affected by a wavelength of incident light. In this regard, the wavelength of light for a light source for recording is being shortened such as in the development of an HD-DVD using a blue laser beam, in a field of an optical recording medium. The present invention can cope with such a technology. The thin film according to the present invention provides merits of reducing the number of errors and extending the life, when applied to the optical recording medium, for instance.

In the present invention, a reflection film has only to have a function of reflecting light, and includes a film having optical transparency. Accordingly, the reflection film according to the present invention can be also applied to a semi-reflective/semi-transparent film used in an optical recording medium.

## Claims

1. A thin film for a reflection film or for a semi-transparent reflection film, having at least one silver compound phase selected from the group consisting of nitride, oxide, complex oxide, nitroxide, carbide, sulfide, chloride, silicide, fluoride, boride, hydride, phosphide, selenide and telluride of silver, dispersed in a matrix formed of silver.

2. The thin film according to claim 1, wherein the silver compound phase has a content of 0.001 to 2.5 wt.%.

3. The thin film according to claim 1, wherein the silver compound phase has a content of 0.001 to 1.0 wt.%.

4. The thin film according to claim 1, wherein the silver compound phase has a content of 0.001 to 0.5 wt.%.

5. A sputtering target having at least one silver compound phase selected from the group consisting of nitride, oxide, complex oxide, nitroxide, carbide, sulfide, chloride, silicide, fluoride, boride, hydride, phosphide, selenide and telluride of silver, dispersed in a matrix formed of silver.

6. The sputtering target according to claim 5, wherein the silver compound phase has a content of 0.001 to 2.5 wt.%.

7. The sputtering target according to claim 5, wherein the silver compound phase has a content of 0.001 to 1.0 wt.%.

8. The sputtering target according to claim 5, wherein the silver compound phase has a content of 0.001 to 0.5 wt.%.

9. An optical recording medium comprising the thin film according to any one of claim 1 to claim 4, as a reflection film or a semi-transparent reflection film.
